# EUROPEAN PATENT SPECIFICATION

(11) **EP 4 123 722 B1**
(45) Date of publication and mention of the grant of the patent: **03.04.2024**
(21) Application number: 21186667.8
(22) Date of filing: 20.07.2021
(51) Int. Cl.: H01L 29/78, H01L 29/06, H01L 29/08

(54) **POWER SEMICONDUCTOR DEVICE**
LEISTUNGSHALBLEITERBAUELEMENT
DISPOSITIF DE SEMI-CONDUCTEUR D'ALIMENTATION

(43) Date of publication of application: 25.01.2023
(73) Proprietor: Hitachi Energy Ltd, 8050 Zürich (CH)
(72) Inventor: ROMANO, Gianpaolo, 5400 Baden (CH); MIHAILA, Andrei, 5415 Rieden (CH); BELLINI, Marco, 8005 Zürich (CH); ARANGO, Yulieth, 8045 Zurich (CH); KNOLL, Lars, 5607 Hägglingen (CH); DONATO, Nazareno, Norwich, Sprowston NR7 8FZ (GB); UDREA, Florin, Cambridge CB2 0RB (GB)
(74) Representative: Epping - Hermann - Fischer

(56) References cited:
- US-A1- 2019 393 299
- US-A1- 2020 098 910
- US-A1- 2020 152 748

## Description

The present disclosure relates to a power semiconductor device.

A power semiconductor device is realized e.g. as a metal-oxide-semiconductor field-effect transistor, abbreviated MOSFET. The MOSFET may be based on a wide band-gap material such as e.g. silicon carbide material, abbreviated SiC material. 650V and 1200V-rated SiC MOSFETs are currently commercially available. Even though the SiC market is mostly driven by low voltage devices, the use of ≥3.3kV SiC power MOSFETs for medium voltage and high voltage systems, like traction applications, has also attracted more attention. Implemented with either planar or trench cell designs, SiC MOSFETs provide competitive static losses, fast dynamic performance and adequate reliability. Regarding the fault handling capability, SiC MOSFETs still fall short of the typical industry standard values shown by their Si counterparts. This is typically associated with the strong trade-off between conduction losses and short-circuit withstand time, abbreviated SCWT.

Document US 2017/0229535 A1 relates to a semiconductor device with a source region having a source contact region, a source extension region and a source resistance control region.

Document US 2019/393299 A1 relates to a Silicon Carbide Semiconductor Device which includes a first load electrode, a normally-on junction field effect transistor, and an insulated gate field effect transistor. The normally-on junction field effect transistor includes a channel region electrically connected to the first load electrode. The insulated gate field effect transistor and the normally-on junction field effect transistor are electrically connected in series. The insulated gate field effect transistor includes a source region and a body region. The source region is electrically connected to a channel region of the normally-on junction field effect transistor. The body is electrically connected to the first load electrode.

Document US 2020/152748 A1 relates to a trench-gate MOSFET, in which, between a channel and an n+-type source region, an n-type shunt resistance region is provided in contact with the n+-type source region and the channel. The n+-type source region is disposed at a position separated from a gate insulating film at a side wall of a trench, in a direction parallel to a front surface of a semiconductor substrate. The n-type shunt resistance region is disposed, positioned deeper toward a drain electrode than is a front surface of the semiconductor substrate and shallower toward a source electrode than is the channel, and reaches a position deeper toward the drain electrode from the front surface of the semiconductor substrate than is the n+-type source region. The n-type shunt resistance region is a resistor for reducing current between the drain and the source when a large current exceeding a rated current flows during a short circuit.

There is a need for a power semiconductor device with an improved trade-off between conduction losses and short-circuit withstand time.

According to an embodiment, a power semiconductor device comprises the technical features defined in claim 1.

In an example, the island surface area is the complete surface of the island region. The island surface area includes the surface of each side of the island region. Thus, the island surface area includes the areas of a bottom surface, of a top surface and of side surfaces of the island region. The island region is e.g. a cuboid such as a rectangular cuboid or a non-rectangular cuboid. The cuboid may have rounded corners and/or edges. A cuboid has six faces or sides. The island surface area exemplarily includes the surface of the six sides of the island region.

"Attaches" shall mean that the island region may be arranged in the source region such that the island region is embedded in the source region. Thus, the island region may be completely surrounded or enclosed by the source region at each side of the island region. The source region may separate the island region from the well layer in 100 % of the island surface area. This means that the island region may be surrounded in each of the three dimensions of the island region by the source region. The island region may be realized as a buried region or buried layer.

Alternatively, "attaches" shall mean that the island region may be arranged on the source region such that the island region extends to the first main surface, but the island region is separated from the well layer in at least 50 % or at least 70 % or at least 80 % or at least 90 % or 100 % of the island surface area. In an example, the separation of the island region from the well layer is realized partly by the source region and partly by an isolator and/or an electrode such as a source electrode. Thus, the island region is not completely embedded or surrounded by the source region. This means that the island region is not surrounded in each of the three dimensions of the island region by the source region. However, in an example the island region is surrounded in two dimensions of the island region by the source region; the two dimensions are e.g. parallel to the first main surface and can be seen e.g. in a top view.

Exemplarily, the island region reduces a cross section of the source region. Thus, the form of the source region and the island region might result in a slightly increased source resistance value. The island region modifies the source resistance in such a way so to enhance the short-circuit withstanding time without affecting too much the on-state resistance.

In an example, the island region is surrounded by the source region at the first main surface of the semiconductor body. The island region extends to the first main surface.

In an example, the island region is surrounded by the source region in a plane which is inside the semiconductor body and is parallel to the first main surface of the semiconductor body. The island region extends or does not extend to the first main surface.

According to at least one embodiment, the well layer comprises a well region separating the source region from the drift layer and a well contact region at the first main surface. The well contact region has a higher maximum doping concentration than the well region.

According to at least one embodiment, the power semiconductor device comprises a source electrode arranged at least at a part of the source region and at least at a part of the well contact region. The source electrode forms an ohmic contact to the source region and to the well contact region.

According to at least one embodiment, the source electrode is free from an ohmic contact to the island region.

According to at least one alternative embodiment, the source electrode is additionally arranged at least at a part of the island region. The source electrode additionally forms an ohmic contact to the island region.

According to at least one embodiment, the power semiconductor device is a field-effect transistor or an insulated gate bipolar transistor, IGBT for short. For example, the power semiconductor device described herein is or is comprised in, for example, a MIS-based (metal insulator semiconductor) or MOS-based (metal-oxide semiconductor). The device may be a trench or a planar device. The semiconductor body may be based on a wide bandgap material such as silicon carbide or gallium nitride, or on silicon. Hence, the power semiconductor device is or can be present in, for example, a device selected from the group comprising or consisting of a metal-oxide-semiconductor field-effect transistor (MOSFET), a metal-insulator-semiconductor field-effect transistor (MISFET) and an insulated-gate bipolar transistor (IGBT).

According to at least one embodiment, the semiconductor body further comprises a collector layer. The collector layer is of the same conductivity type as the well region. The collector layer may be located at the second main surface of the semiconductor body (named bottom side of the semiconductor body) opposite the first main surface (named top side). There can be one collector layer for all the source regions. The collector layer may be named backside layer. A collector electrode can be directly applied to the collector layer. If there is a collector layer, the power semiconductor device can be an IGBT.

According to at least one embodiment, the semiconductor further comprises at least one drain region. The drain region is of the same conductivity type as the at least one source region. For example, the drain region is a layer at the second main surface. The drain region may be named or may be formed by a backside layer. For example, the drift region is located between the first main surface and the drain region. There can be one common drain region for all the source regions. A drain electrode may be in direct contact with the at least one drain region. If there is a drain region, the power semiconductor device can be a MOSFET or a MISFET.

The drain layer has a higher doping concentration than the drift layer.

The semiconductor body is made, for example, of a wide band-gap material. The wide band-gap material is e.g. one of silicon carbide SiC, gallium nitride GaN and gallium oxide Ga₂O₃ or another wide-bandgap material. The power MISFET or power MOSFET is based on a wide band-gap material, for example, silicon carbide material. Thus, the power semiconductor device could be realized as a SiC MOSFET or SiC MISFET.

The power semiconductor device is a power device. For example, the power semiconductor device is configured for a maximum voltage of at least 0.1 kV or at least 0.5 kV.

In an example, the island region is realized by a shallow implantation of the second conductivity type. The second conductivity type is e.g. p conductivity or p doping.

In an example, the MOSFET or MISFET includes a shallow p-implant for enhanced short-circuit capability. The p island is additionally implanted in the source region to provide an improved trade-off between conduction losses and SCWT. The source resistance, increased by the additional p+ implant, reduces the SCWT without increasing too much the on-state resistance.

The present disclosure comprises several aspects. Every feature described with respect to one of the aspects is also disclosed herein with respect to the other aspect, even if the respective feature is not explicitly mentioned in the context of the specific aspect.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figures 1A and 1B are a perspective view and a top view of a power semiconductor device according to an example;
Figures 2A to 2H are top views of a power semiconductor device according to different examples and in particular, Figures 2C, 2D, 2G and 2H show embodiments of the invention while Figures 2A, 2B, 2E and 2F show power semiconductor devices not forming part of the claimed invention.
Figure 3 are cross sections of a power semiconductor device which is not part of the claimed invention;
Figures 4A and 4B show simulated characteristics of a power semiconductor device according to different examples not forming part of the claimed invention;
Figures 5A to 5E are top views of a power semiconductor device and of an island region according to different examples not forming part of the claimed invention;
Figures 6A to 6C show a perspective view and cross section views of a simulated structure of a power semiconductor device according to an embodiment, and
Figure 7 show simulated characteristics of a power semiconductor device according to an embodiment.

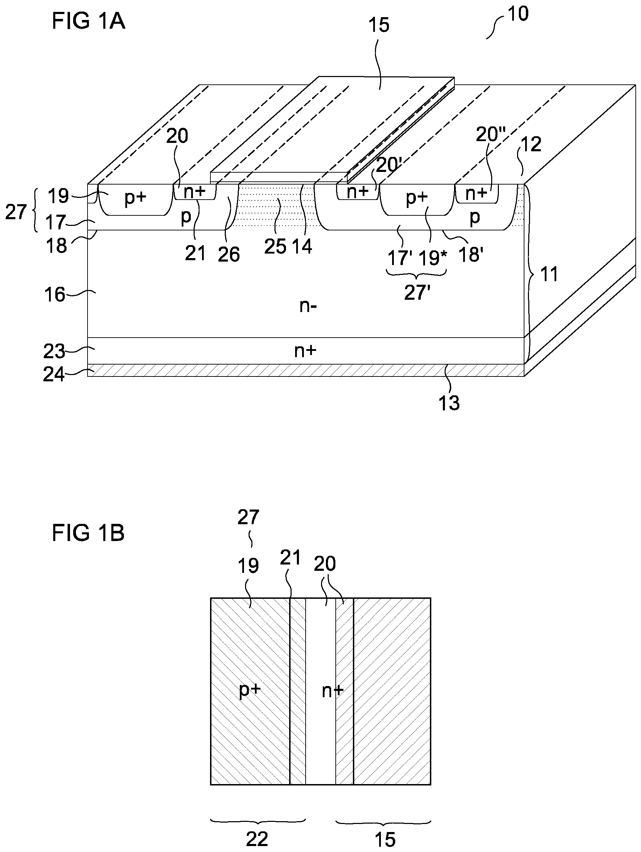

Figures 1A and 1B are a perspective view and a top view of a power semiconductor device 10. The power semiconductor device 10 is realized as a MOSFET or MISFET, such as e.g. a SiC MOSFET or SiC MISFET. A typical perspective view of the power semiconductor device 10 realized as MOSFET or MISFET is depicted in Figure 1A, while a top view of its source design is shown in Figure 1B. The power semiconductor device 10 comprises a semiconductor body 11, a gate insulator 14 and a gate electrode 15. The semiconductor body 11 is realized, for example, as a wide band-gap substrate which is e.g. a silicon carbide semiconductor substrate. The semiconductor body 11 includes a first main surface 12 and a second main surface 13. Silicon carbide is abbreviated as SiC. The gate insulator 14 is arranged at or on the first main surface 12 of the semiconductor body 11. The gate electrode 15 is arranged at or on the gate insulator 14.

The semiconductor body 11 comprises a drift layer 16 of a first conductivity type, a well layer 27 of a second conductivity type, and a source region 20 of the first conductivity type. The second conductivity type is different from the first conductivity type. The well layer 27 may comprise a well region 17 and a well contact region 19, both of the second conductivity type. The well layer 27 separates the source region 20 from the drift layer 16. The well region 17 forms a first junction 18 to the drift layer 16. The well contact region 19 is e.g. inside the well region 17. Alternatively, the well contact region 19 may have the same depth or even a larger depth than the well region 17. The source region 20 forms a second junction 21 to the well layer 27 and, thus, to the well region 17 and to the well contact region 19.

The semiconductor body 11 comprises a backside layer 23 of the first conductivity type located at the second main surface 13. The power semiconductor device 10 comprises a drain electrode 24 arranged at the backside layer 23. The backside layer 23 realizes e.g. a drain region. The drain electrode 24 forms an ohmic contact to the backside layer 23. The drift layer 16 comprises a junction field-effect transistor region 25 (abbreviated JFET region) adjacent to the well region 17. A region located inside the well region 17 and between the source region 20 and the JFET region 25 forms a channel 26, when the power semiconductor device 10 is set in a conducting state. The channel 26 is located inside the well region 17 at the interface to the gate insulator 14.

The semiconductor body 11 comprises a further well layer 27' of the second conductivity type and further source regions 20', 20'' of the first conductivity type. The further well layer 27' comprises a further well region 17' of the second conductivity type and a further well contact region 19* of the second conductivity type. The power semiconductor device 10 is e.g. symmetrically with respect to a middle line running in the middle of the gate electrode 15. Thus, in the following figures only the "left part" of the power semiconductor device 10 is discussed, since the "right part" corresponds to the "left part".

The power semiconductor device 10 comprises a gate comprising e.g. parallel stripes as shown in Figure 1A or a meshed gate with cells. The cells are one of square, rectangular or hexagonal form or have another form.

For example, the power semiconductor device 10 is of a cell design. This may mean that, seen in top view, the gate electrode 15 is of, for example, but not limited to, square or nearly square shape. Otherwise, the power semiconductor device 10 can be of a stripe design so that the gate electrode 15 is considerably longer than wide. Both in the cell design and the stripe design, there can be a plurality of the gate electrodes 15.

For example, the gate electrode 15 is of planar configuration. Hence, the gate electrode 15 is located on the first main surface 12 (named top side) of the semiconductor body 11 and the first main surface 12 is of planar fashion. In this case, neither the gate electrode 15 nor the gate insulator 14 penetrate in the semiconductor body 11.

According to an alternative, the gate electrode 15 is of trench configuration. In this case, the gate electrode 15 extends into a trench of the semiconductor body 11. For example, the gate insulator 14 covers side walls of the trench and a bottom of the trench. The gate electrode 15 is arranged on the gate insulator 14 inside the trench. Thus, the gate insulator 14 insulates the gate electrode 15 from any doped layer in the semiconductor body 11.

In the example shown in Figures 1A and 1B, the first conductivity type is n doped and the second conductivity type is p doped. In an example, structures of one cell of the power semiconductor device 10 are shown in Figure 1A. The power semiconductor device 10 e.g. comprises a number of cells, corresponding to the cell shown in Figure 1A and discussed in detail in the Figures below.

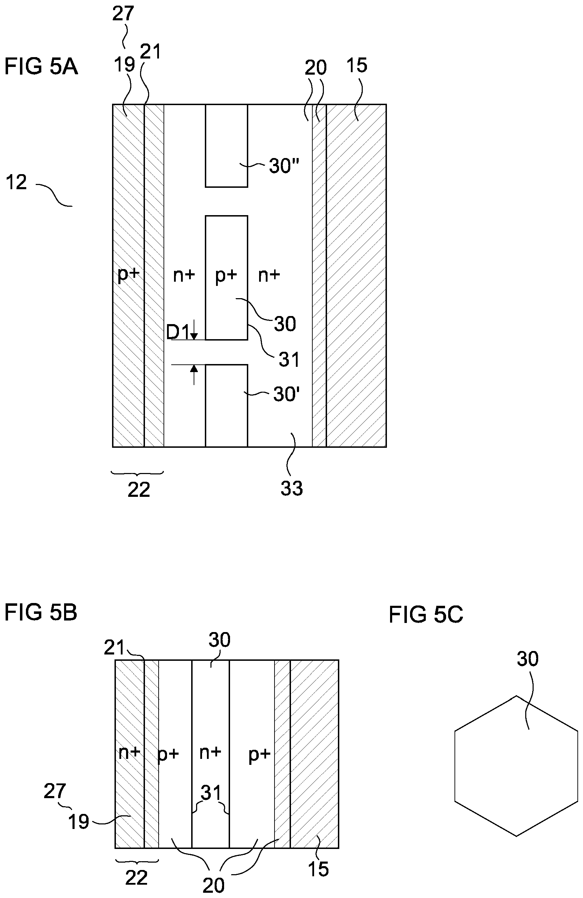

In an alternative example shown in Figure 5B, the first conductivity type is p doped and the second conductivity type is n doped. Thus, in the figures, n and p are interchanged.

For example, maximum doping concentrations of the source region 20, the backside layer 23 or drain region and the well contact region 19 are in a range between 1·10¹⁸ cm⁻³ and 5·10²⁰ cm⁻³. Further, a maximum doping concentration of the well region 17 may be 1·10¹⁶ cm⁻³ or higher. Depending on the voltage class of the power semiconductor device 10, a maximum doping concentration of the drift region 16 may be in a range between 1·10¹⁴ cm⁻³ and 1·10¹⁷ cm⁻³.

As shown in Figure 1B, the power semiconductor device 10 comprises a source electrode 22 arranged at least at a part of the source region 20 and at least at a part of the well contact region 19. The source electrode 22 forms an ohmic contact to the source region 20 and to the well contact region 19. The gate electrode 15 and the source electrode 22 are drawn hatched in Figures 1B, 2A to 2H, 5A and 5B. The gate electrode 15 is on top of the gate insulator 14 which is on top of the semiconductor body 11. The source electrode 22 is on top of the semiconductor body 11. The gate electrode 15 and the gate insulator 14 have an overlap with the source region 20. A part of the gate electrode 15 is above, but not in contact with, a part of the source region 20.

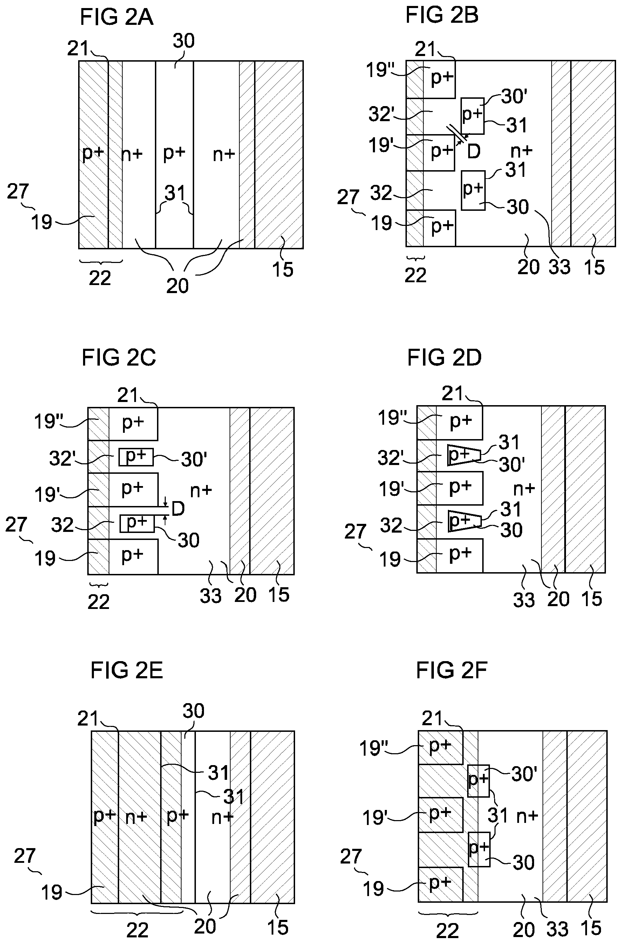

Figure 2A is a top view of a power semiconductor device 10 according to an example not forming part of the claimed invention which is a further development of the device shown in Figures 1A and 1B. The semiconductor body 11 comprises an island region 30 of the second conductivity type. The island region 30 is surrounded by the source region 20 in a plane parallel to the first main surface 12 of the semiconductor body 11. Thus, the island region 30 is surrounded by the source region 20 in at least two dimensions (namely the dimension that is parallel to the longer sides of the island region 30 and the dimension that is perpendicular to the first main surface 12). At the first main surface 12, the source region 20 separates the island region 30 from the junction field-effect transistor region 25. At the first main surface 12, the source region 20 separates the island region 30 from the well contact region 19. The island region 30 shown in Figure 2A has two long sides which both are attached to areas of the source region 20. Side surfaces of the two long sides of the island region 30 are attached to areas of the source region 20.

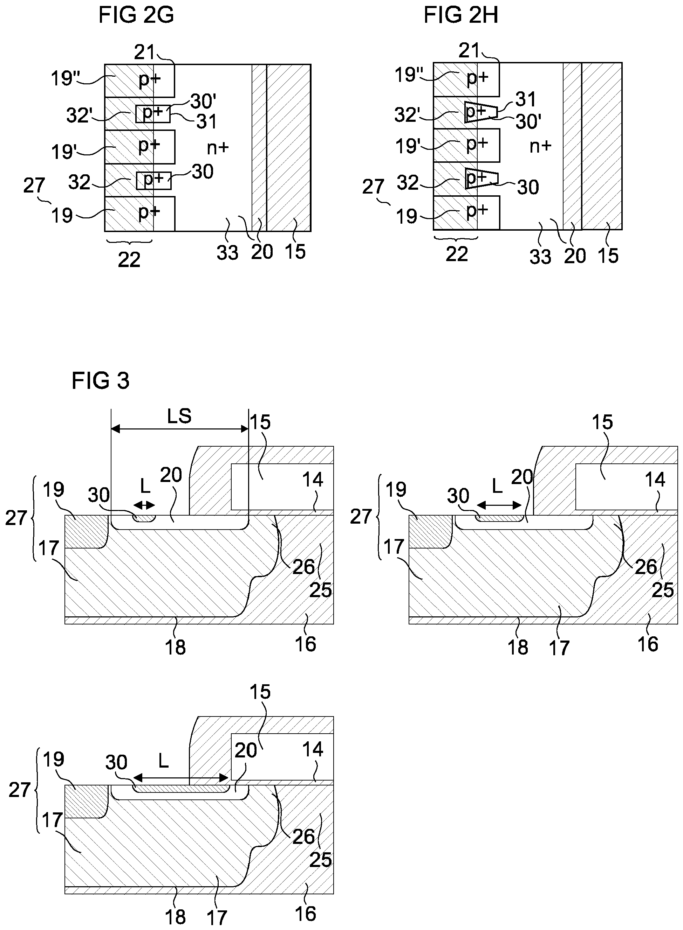

Exemplarily, the source region 20 is also attached to a bottom surface of the island region 30 (e.g. as shown in Figure 3). Thus, the island region 30 is surrounded by the source region 20 in three dimensions (namely the dimension that is parallel to a width of the island region 30, the dimension that is parallel to the longer sides of the island region 30, and the dimension that is perpendicular to the first main surface 12).

Thus, the power semiconductor device 10 is realized, for example, as a SiC MOSFET or SiC MISFET with additional p+ implantation in the source region 20. The island region 30 forms a third junction 31 to the source region 20. The well region 17, the well contact region 19, the source region 20 and the island region 30 are located at the first main surface 12. In an example, the well contact region 19 and the island region 30 are highly p doped; the well region 17 is p doped, i.e. lower doped than the island region 30 or the well contact region 19; the source region 20 and the backside layer 23 are highly n doped; and the drift layer 16 is weakly n doped, i.e. lower doped than the source region 20. In an example, the well contact region 19 and the island region 30 have the same maximum doping concentration. Alternatively, the well contact region 19 and the island region 30 have different maximum doping concentrations. The well contact region 19 and the island region 30 are doped not necessarily with the same doping level.

The island region 30 may be arranged at the source region 20 at the first main surface 12. In another embodiment, the island region 30 is arranged in the source region 20 such that the source region 20 completely surrounds the island region 30.

The active area of the semiconductor device, which is the area between the main electrode on the first main surface 12 (which may be the source electrode 22) and a backside electrode on a backside side of the semiconductor body (which may be the drain electrode 24 or a collector electrode). The island region 30 is arranged in the active area.

The island region 30 has the form of a cuboid such as a rectangular cuboid. In a top view, the island region 30 has the form of a rectangle. The rectangle may have rounded corners or sharp corners. The two longer sides of the rectangle of the island region 30 completely adjoin the source region 20. In an example, the material (not shown) at the smaller sides of the rectangle of the island region 30 are further parts of the source region 20 or is formed by an isolator or an isolating structure. Alternatively, the island region 30 forms a ring structure. The island region 30 is formed as a rectangle in a plane parallel to the first main surface 12.

The island region 30 is realized as a shallow region. A part of the source region 20 is "under" the island region 30. A depth of the island region 30 is less than a depth of the source region 20. The depths are measured starting from the first main surface 12. Thus, a part of the source region 20 between the well contact region 19 and the island region 30 is connected to and/or has a conductive path to a part of the source region 20 between the well region 17 and the island region 30. Moreover, the part of the source region 20 between the well contact region 19 and the island region 30 is connected to and/or has a conductive path to a part of the source region 20 between the channel 26 and the island region 30. The island region 30 is free from a conducting contact to the drift layer 16 via a semiconductor region. The island region 30 is free from a conducting contact to the well layer 27 via a semiconductor region. The island region 30 is free from a conducting contact to the well contact region 19 via a semiconductor region. The island region 30 is free from a conducting contact to the well region 17 via a semiconductor region.

The further well region 17' (not shown) corresponds to the well region 17. The further well contact region 19* (not shown) corresponds to the well contact region 19. The further source region 20' (not shown) corresponds to the source region 20. A further island region (not shown) of the semiconductor body 11 corresponds to the island region 30. As shown in Figures 2A to 2D, the source electrode 22 is free from an ohmic contact to the island region 30. That means that the island region 30 is not electrically connected to a fixed potential. The island region 30 is electrically floating. Since the MOSFET or MISFET is fabricated using an additional p+ implantation in the source region 20, a resistance of the source region 20 could be increased.

Figure 2B is a top view of a power semiconductor device 10 according to an example not forming part of the claimed invention which is a further development of the examples shown in Figures 1A, 1B and 2A. The source region 20 has the form of an interdigitated fingers structure or includes an interdigitated fingers structure. The well layer 27 is located between fingers 32, 32' of the interdigitated fingers structure. The well contact region 19 is located between fingers 32, 32' of the interdigitated fingers structure. The source region 20 comprises a stripe 33. The fingers 32, 32' of the interdigitated finger structure are connected to the stripe 33 in a connection area. The fingers 32, 32' extend from this stripe 33 in the direction of the well contact region 19 and/or the source electrode 22. The source region 20 has a number M of fingers 32, 32'. In Figure 2B, the number M is 2. For example, the number M is at least 2 or much higher. The number of fingers is anyway such that the interdigitated fingers structure extends e.g. for the entire stripe length of the stripe 33 or for a part of the entire stripe length.

The island region 30 is completely surrounded by the source region 20 at the first main surface 12 of the semiconductor body 11. The island region 30 is located in the stripe 33 in the connection area at the first main surface 12. The island region 30 is in proximity to a first and a second part of the well contact region 19, 19'. The island region 30 is in proximity to exactly one finger 32 of the interdigitated finger structure. A distance D is considered as the minimum distance of the island region 30 to the well contact region 19 and to the well contact region 19'. The distance D can be equal or greater than 0.05 µm.

A maximum doping concentration of the island region 30 is in a range between 0.5·10¹⁸ cm⁻³ and 2·10²¹ cm⁻³, alternatively, in a range between 10¹⁸ cm⁻³ and 10²⁰ cm⁻³.

In the top view shown in Figure 2B, the island region 30 has the form of, for example, a rectangle. In an example, the rectangle has the form of a square. The semiconductor body 11 includes a number N of island regions 30, 30'. For example, the island regions of the number N of islands regions 30, 30' are identically formed. The number M of fingers 32, 32' is equal to the number N of island regions 30, 30'. Alternatively, the number M of fingers 32, 32' is larger than the number N of island regions 30, 30'. In Figure 2B, the number N is 2. Alternatively, the number N of island regions 30, 30' is at least one or at least two, or much higher.

The number N of island regions 30, 30' attaches the source region 20 such that the source region 20 separates an island region of the number N of island regions 30, 30' from the well layer 27 in a portion, e.g. at least 50 %, of an island surface area of the number N of island regions 30, 30'. In an example, the source region 20 separates each of the island regions of the number N of island regions 30, 30' from the well layer 27 in a portion, e.g. at least 50 %, of an island surface area of said island region 30.

Figure 2C is a top view of a power semiconductor device 10 according to an embodiment which is a further development of the examples shown above. The island region 30 is located in a finger 32 of the interdigitated finger structure at the first main surface 12. The island region 30 is located between two parts of the well contact region 19, 19'. In the top view shown in Figure 2C, the island region 30 has the form of a rectangle.

Figure 2D is a top view of a power semiconductor device 10 according to an embodiment which is a further development of the examples shown above. The island region 30 is located in a finger 32 of the interdigitated finger structure at the first main surface 12. In the top view shown in Figure 2D, the island region 30 has the form of a trapezoid. A width of the trapezoid is smaller near the stripe 33. Alternatively, a width of trapezoid is greater near the stripe 33. The island region 30 is formed as a trapezoid in a plane parallel to the first main surface 12.

The island region 30 has a form of a rectangle as shown in Figures 2A to 2C or a trapezoid as shown in Figure 2D at the first main surface 12 of the semiconductor body 11. Other forms of the island region 30 are possible such as e.g. a circle, an ellipse, a triangle, a rhombus, a pentagon, a hexagon etc. in a top view.

In Figures 2A to 2D, the island region 30 is floating, i.e. it does not have any electrical connection to any of the electrodes. The island region 30 is free from any metal connection. The island region 30 is surrounded inside the semiconductor body 11 by the source region 20. The island region 30 is covered by a not shown isolator at the first main surface 12. Each of the number N of islands regions 30, 30' is floating. In an example, the island regions 30, 30' of the number N of island regions are realized identically.

Figures 2E to 2H are top views of a power semiconductor device 10 which is a further development of the examples and embodiments shown above, e.g. shown in Figures 2A to 2D. Figures 2E and 2F show examples not forming part of the claimed invention and Figures 2G and 2H show embodiments forming part of the claimed invention.

The source electrode 22 is arranged at least at a part of the island region 30. The source electrode 22 forms an ohmic contact to the island region 30. The island region 30 is electrically connected to the source region 20 and the well contact region 19 by the source electrode 22.

Different layouts for source design, with several configurations of the additional shallow p+ implantation or implantations realizing the island region 30 or island regions 30, 30', are shown in Figures 2A to 2H (top view). The n+ and p+ regions can either have a simple stripe-like design, as shown in Figures 2A and 2E, or they can have nonuniform design in the third dimension as shown in Figures 2B to 2D and 2F to 2H, e.g. the p+ area is segmented, and additional implanted islands 30, 30' are included.

The power semiconductor device 10 implements several features:
- The well contact region 19, realized by p+ regions, and the source region 20, realized by n+ regions, can have a "finger"-like design as shown in Figures 2B to 2D and 2F to 2H.
- The island regions 30, 30', realized by p+ islands, can be implanted near the fingers 32, 32' of the source region 20, realized by n+ fingers, as in Figures 2B and 2F.
- The island regions 30, 30', realized by p+ regions, can be placed between the p+ parts of the well contact region 19 and have different shapes as shown in Figures 2B to 2D and 2F to 2H.

The island regions 30, 30', realized by an additional p+ implant, can either be left floating (as shown in Figures 2A to 2D) or can be shorted with the source region 20 through the source electrode 22, realizing a metal contact, as shown in Figures 2E to 2H. For any of the described layouts, if the doping profile of the island could be chosen equal to the well contact region, the proposed design does not require any additional masks for fabrication, and the additional p+ implantation can be realized during the contact process step or steps.

In an example, a mask for realizing the well contact region 19 includes further structures for realizing the island region 30. The island region 30 and the well contact region 19 are implanted together in a common implantation process.

In an alternative example, the set of masks for producing the power semiconductor device 10 includes a mask for realizing the island region 30. The island region 30 is implanted in an implantation process separately from other implantation processes such as e.g. the implantation process for the well contact region 19. In this case, the doping profile of the island region 30 could be different from the doping profile of the well contact region 19.

In the region under the island region 30, a part of the source region 20 separates the island region 30 from the well region 17.

The depth of the p+ island region 30 can be used as a design parameter and can go up to 95% of depth of the n+ source region 20. The dimensions of the p+ stripe/regions and their distance with the p+ fingers can vary, as well as their doping. The distance D is the smallest distance of the island region 30 to the well contact region 19 and can be used as additional design parameter. The maximum doping concentration in the island region 30 can go from 0.5 10¹⁸ cm⁻³ up to 10²¹ cm⁻³, and can also be used as design parameter. The overlay of the top metal realizing the source electrode 22 with the source region 20 and/or the island regions 30, 30' (named additional p+ implants) can also be used as design parameter.

In Figures 2A to 2H, a part of the power semiconductor device 10 is shown. The part can be a part of at least one of a MOSFET or MISFET with parallel stripes and a MOSFET or MISFET with meshed gate.

Figure 3 are cross sections of a power semiconductor device 10 according to different embodiments which is a further development of the embodiments shown above. In Figure 3, a source design for the layouts in Figures 2A or 2E for different values of an implant length L is shown. The island region 30 is realized as a shallow region having a thickness less than a thickness of the source region 20. A thickness of the island region 30 is, as example, in this case less than 95% or less than 50% of a thickness of the source region 20. In an example, a thickness of the island region 30 is less than a thickness of the well contact region 19.

A source region length LS is an extension of the source region 20 parallel to the main current flow in the source region 20. The source region length LS is a distance of the well contact region 19 to the channel region 26, e.g. the shortest distance of the well contact region 19 to the channel region 26. An island region length L is an extension of the island region 30 in a direction between the well contact region 19 and the channel region 26 (the channel region 26 and the well contact region 19 have both gaps to the island region 30). The extension of the source region 20 with the source region length LS is parallel to the extension of the island region 30 with the island region length L. The source region length LS is in the same direction as the island region length L. The island region length L has a value in a range between 5 % and 95 % of the source region length LS. According to the examples shown in Figure 3, the source region 20 separates the island region 30 from the well layer 27 in at least 50 % (e.g. in more than 50 %) of an island surface area of the island region 30. The island surface area of the island region 30 may be completely (that is 100%) separated from the well layer 27. The island surface area is covered partly by the source region 20 and partly by an isolator and/or an electrode (not shown) such as the source electrode 22.

The layouts of Figure 2A and Figure 2E have been investigated by means of Technology Computer-Aided Design (TCAD) simulations, considering as example a structure representing a 1.2kV-rated device, for different values of the island region length L (about 20% of LS, 40% of LS and 75% of LS). The depth of the island region 30, also named thickness of the island region 30 or implantation depth, was set to 30% of the source region depth and its maximum doping concentration to 10²⁰ cm⁻³.

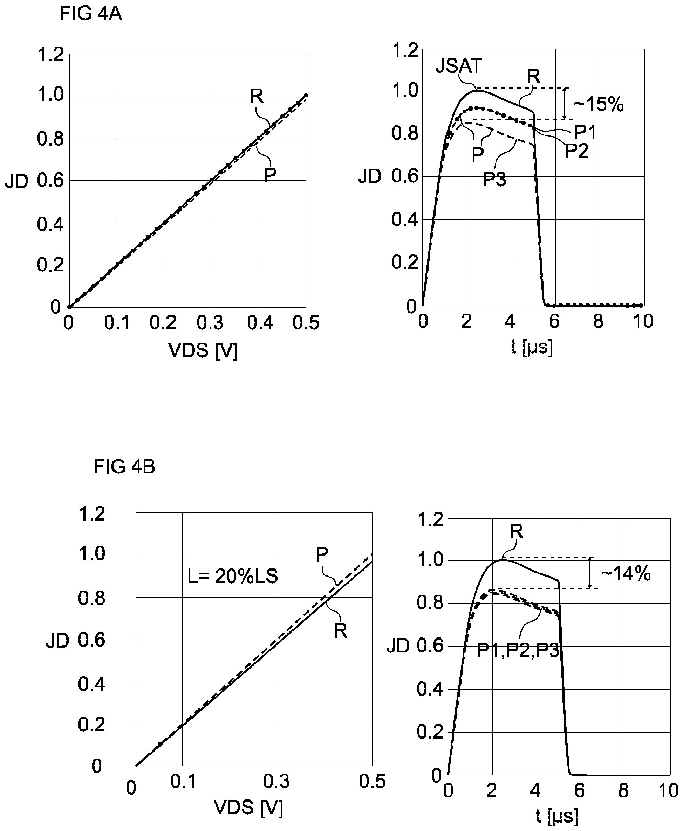

Figure 4A and 4B are simulated characteristics of a power semiconductor device 10 according to an example not forming part of the claimed invention. In Figure 4A, static output characteristics (left side) and short-circuit waveforms (right side) of the source design of Figure 2E (data marked with P or P1, P2, P3) is compared to a reference MOSFET structure (data marked with R). The data were generated for different values of the island region length L (namely about 20%, 40% and 75% of the source region length LS) by simulations. The reference MOSFET is simulated using the same parameters as the proposed design (in terms of doping, dimensions etc.) but without island regions.

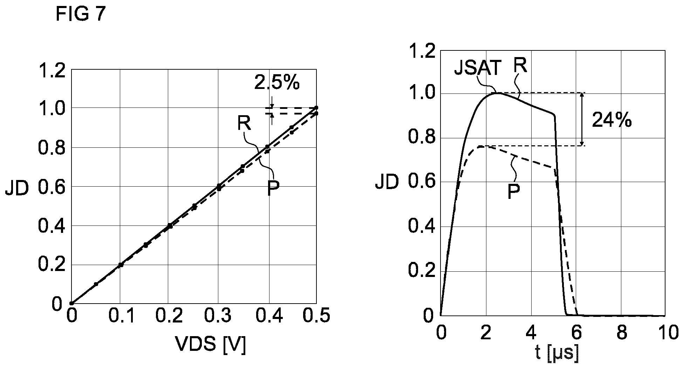

On the left side, a drain current density JD is shown as a function of a drain-source voltage VDS. The following parameters were used: gate-source voltage VGS = 15 V, and temperature T = 300 K. The drain current density JD is normalized to 1 with respect to the maximum in the Figures 4A and 4B. On the right side, the drain current density JD, during an electro-thermal short-circuit simulation, is shown as a function of a time t. The following parameters were used: gate-source voltage VGS = -10 V/+15 V; temperature T = 300 K; and drain-source voltage VDS = 600 V. These parameter for the characteristics on the left and right side were also used for Figures 4B and 7.

The static output characteristics (left side) and short-circuit waveforms (right side) of Figure 4A are obtained using the source design of Figure 2E for grounded p+ implant. The largest reduction of the peak value of the drain current density JD during short circuit in comparison to the reference MOSFET is achieved with L = 75% LS (data are marked with P3) and is about 15%. The reductions using L = 20% LS (data are marked with P1) and L = 40% LS (data are marked with P2) are nearly identical.

The static output characteristics (left side) and short-circuit waveforms (right side) of Figure 4B are obtained using the source design of Figure 2A for floating p+ implant. The reductions of the peak value of the drain current density JD in comparison to the reference MOSFET are nearly identical for the three different values of L and are about 14% in an example.

The two cases of both grounded and floating p+ implant have been considered. The resulting output and short-circuit waveforms are reported in Figures 4A and 4B, respectively. There is almost no difference in static performances compared to the reference design (left side), while a reduction up to e.g. 15% can be achieved for the maximum drain current density during short circuit (right side). Additionally, the breakdown voltage is not affected by the additional implantation in the source region 20.

Figure 5A is a top view of a power semiconductor device 10 according to an example not forming part of the claimed invention which is a further development of the examples shown above. The island region 30 is completely surrounded by the source region 20 at the first main surface 12 of the semiconductor body 11. The number N of island region 30, 30', 30'' are arranged e.g. on a straight line or on a ring line. A gap between two adjacent island regions 30, 30' has a distance D1. The distance D1 is larger e.g. than 0.05 µm or larger than 0.5 µm.

Figure 5B is a top view of a power semiconductor device 10 according to an example not forming part of the claimed invention which is a further development of the examples shown above, e.g. as shown in Figure 2A. The first conductivity type is p doped and the second conductivity type is n doped.

Figure 5C is a top view of an island region 10. The island region 30 is formed as a polygon such as a hexagon, exemplarily as a regular hexagon, in a top view on the first main surface 12 or in a plane parallel to the first main surface 12. The polygon may have other forms such as triangle, tetragon, pentagon, heptagon etc.

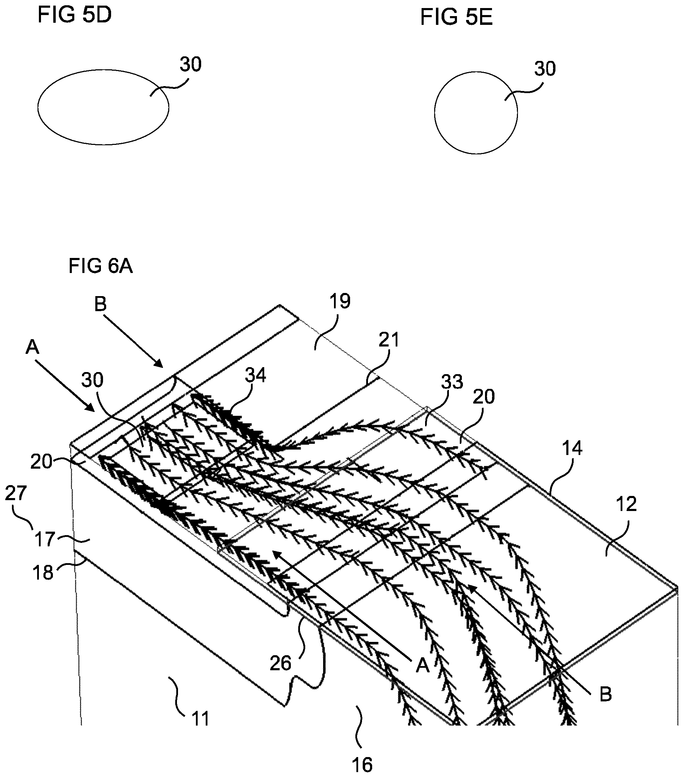

Figure 5D is a top view of an island region 10. The island region 30 is formed as an oval such as an ellipse in a top view on the first main surface 12 or in a plane parallel to the first main surface 12.

Figure 5E is a top view of an island region 10. The island region 30 is formed as an oval such as a circle in a top view on the first main surface 12 or in a plane parallel to the first main surface 12. The circle is a special form of an ellipse. The island region 30 has the form of a cylinder (e.g. in a perspective view). The island region 30 shown in Figures 5C to 5E can be located such as an island region or each or the island regions of the number N of island regions 30, 30', 30'' shown in Figures 2A to 2H and 5A.

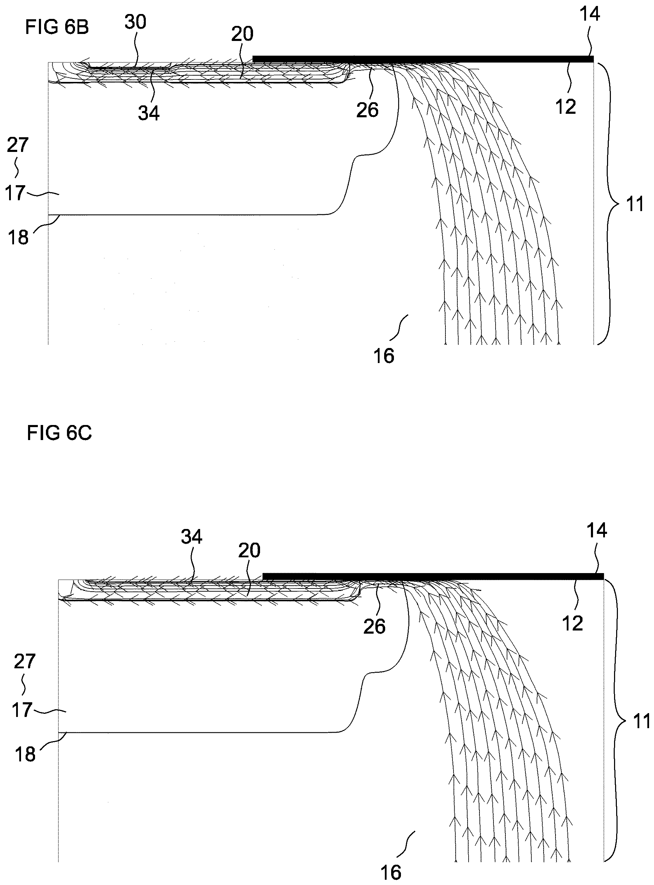

Figure 6A is a perspective view and Figures 6B and 6C are cross-sections of a simulated structure of a power semiconductor device 10 according to an embodiment which is a further development of the embodiments shown above, e.g. of Figure 2C. The simulated current density stream-lines for the proposed design are reported in Figure 6A as 3D view, and in Figures 6B and 6C as 2D cross-sections. In Figure 6B, the cross-section marked with AA in Figure 6A is shown. In Figure 6C, the cross-section marked with BB in Figure 6A is illustrated. Current paths are shown as lines with arrows. In areas 34 the lines are very dense. Areas 34 are areas with the highest current density. The 3D view shows how the p+ shallow implant constraints the current during short circuit, thus increasing the source resistance and leading to a self-limiting effect. In Figures 6A to 6C, a simulated current density (measured in A cm ⁻²) is shown during short-circuit pulse in correspondence of the current peak for the proposed design of Figure 2C.

A high current density exists in the source region 20 in the gap between the island region 30 and the well contact region 19, as shown in Figure 6A. Additionally, a high current density exists inside the source region 20 under the island region 30 that means in the part of the source region 20 that fills the gap between the island region 30 and the well region 17, as shown in Figure 6B. The high current density in the areas 34 which is increased with respect to other areas of the source region 20 has positive effects during short-circuit. Advantageously, the island region 30 results in a reduction of the peak value JSAT of the drain current density JD in short-circuit, as illustrated in Figure 7. However, the areas 34 have only a small negative effect or have no effect on the overall on-state resistance of the device 10 during normal operation.

Figure 7 are characteristics of a power semiconductor device 10 according to an embodiment which is a further development of the embodiments shown above. In Figure 7, static output characteristics (left side) and short-circuit waveforms (right side) of the source design of Figure 2C represented in perspective view in Figure 6 (data marked with P) is compared to a reference MOSFET structure (data marked with R).

On the left side, the drain current density JD is shown as a function of the drain-source voltage VDS. The structure with the proposed source design of Figure 2C has less than 2.5% reduction of the drain current density, i.e. a less than 2.5% increase of the specific on-resistance. The percentage value 2.5 % is only an example for an analyzed case. The following parameters were used: gate-source voltage VGS = 15 V, and temperature T = 300 K. The drain current density JD is normalized to 1 with respect to the maximum.

On the right side, the drain current density JD, during an electro-thermal short-circuit simulation, is shown as a function of a time t. In the analyzed example, the proposed design has about 24 % reduction of the peak value of the drain current density JD in comparison to the reference MOSFET. The following parameters were used: gate-source voltage VGS = -10 V/+15 V; temperature T = 300 K; and drain-source voltage VDS = 600 V.

In Figure 7, the simulated isothermal output JD-VDS curves and the electrothermal short-circuit waveforms (a swing of VGS is between -10V and +15V) for the device 10 of Figure 2C are shown, compared to the standard MOSFET design. A resistance value RON increases by a small amount, while a peak value JSAT, peak of the drain current density JD in short-circuit decreases significantly. Since the energy the power semiconductor device 10 is subjected to during short circuit is directly related to the maximum value of JSAT, the proposed design improves the short-circuit withstanding time without significantly affecting the conduction losses.

The embodiments shown in the Figures 1 to 7 as stated represent exemplary embodiments of the improved power semiconductor device; therefore, they do not constitute a complete list of all embodiments according to the improved power semiconductor device. Actual power semiconductor devices may vary from the embodiments shown in terms of arrangements, devices, structures, layouts and layers for example. The scope of the present invention is defined by the appended claims.

### Reference Signs

- 10: power semiconductor device
- 11: semiconductor body
- 12: first main surface
- 13: second main surface
- 14: gate insulator
- 15: gate electrode
- 16: drift layer
- 17, 17': well region
- 18, 18': first junction
- 19, 19', 19'': well contact region
- 19*: further well contact region
- 20, 20', 20'': source region
- 21: second junction
- 22: source electrode
- 23: backside layer
- 24: drain electrode
- 25: junction field-effect transistor region
- 26: channel
- 27, 27': well layer
- 30, 30': island region
- 31: third junction
- 32, 32': finger
- 33: stripe
- 34: area
- D: distance
- JD: drain current density
- L: island region length
- LS: source region length
- t: time
- VDS: drain-source voltage

## Claims

1. A power semiconductor device (10), comprising:
- a semiconductor body (11) which includes a first main surface (12) and a second main surface (13),
- a gate insulator (14) arranged at the first main surface (12), and
- a gate electrode (15) separated from the semiconductor body (11) by the gate insulator (14),
wherein the semiconductor body (11) comprises
- a drift layer (16) of a first conductivity type,
- a well layer (27) of a second conductivity type being different from the first conductivity type and forming a first junction (18) to the drift layer (16),
- a source region (20) of the first conductivity type forming a second junction (21) to the well layer (27), and
- an island region (30) of the second conductivity type, wherein the source region (20) separates the island region (30) from the well layer (27) in at least 50 % of an island surface area of the island region (30) in the semiconductor body (11), **characterized in that**
- the source region (20) has the form of an interdigitated finger structure,
- the well layer (27) is located between fingers (32, 32') of the interdigitated finger structure,
- the island region (30) is located in a finger (32) of the interdigitated finger structure at the first main surface (12) .

2. The power semiconductor device (10) of claim 1,
wherein the well layer (27) comprises a well region (17) separating the source region (20) from the drift layer (16) and a well contact region (19) at the first main surface (12) which has a higher maximum doping concentration than the well region (17).

3. The power semiconductor device (10) of claim 2,
wherein a distance (D) of the island region (30) to the well contact region (19) is larger than 0.05 µm.

4. The power semiconductor device (10) of claim 2 or 3,
wherein the power semiconductor device (10) comprises a source electrode (22) arranged at least at a part of the source region (20) and at least at a part of the well contact region (19),
wherein the source electrode (22) forms an ohmic contact to the source region (20) and to the well contact region (19), and
wherein the source electrode (22) is free from an ohmic contact to the island region (30).

5. The power semiconductor device (10) of claim 2 or 3,
wherein the power semiconductor device (10) comprises a source electrode (22) arranged at least at a part of the source region (20) and at least at a part of the well layer (27) and at least at a part of the island region (30), and wherein the source electrode (22) forms an ohmic contact to the source region (20) and to the well layer (27) and to the island region (30).

6. The power semiconductor device (10) of one of claims 1 to 5,
wherein the island region (30) is free from a conducting contact to the drift layer (16) via a semiconductor region and is free from a conducting contact to the well layer (27) via a semiconductor region.

7. The power semiconductor device (10) of one of claims 1 to 6,
wherein a maximum doping concentration of the island region (30) is in a range between 0.5 10¹⁸ cm⁻³ and 2 10²¹ cm⁻³.

8. The power semiconductor device (10) of one of claims 1 to 7,
wherein the island region (30) is formed as a one of a group comprising a rectangle, a trapezoid, a hexagon, a circle and an ellipsoid in a plane parallel to the first main surface (12) .

9. The power semiconductor device (10) of one of claims 1 to 8, wherein at least one of:
- the semiconductor body (11) is of a wide bandgap material or of silicon carbide or of silicon, or
- the power semiconductor device (10) is a field-effect transistor or an insulated gate bipolar transistor.

10. The power semiconductor device (10) of one of claims 1 to 9,
wherein a thickness of the island region (30) is less than 95% of a thickness of the source region (20).

11. The power semiconductor device (10) of one of claims 1 to 10,
wherein the semiconductor body (11) includes a number N of island regions (30).

12. The power semiconductor device (10) of one of claims 1 to 11,
wherein an island region length (L) of the island region (30) has a value in a range between 5 % and 95 % of a source region length (LS) of the source region (20).

## Patentansprüche

1. Leistungshalbleitervorrichtung (10), die Folgendes umfasst:
- einen Halbleiterkörper (11), der eine erste Hauptfläche (12) und eine zweite Hauptfläche (13) beinhaltet,
- einen Gate-Isolator (14), der an der ersten Hauptfläche (12) angeordnet ist, und
- eine Gate-Elektrode (15), die von dem Halbleiterkörper (11) durch den Gate-Isolator (14) getrennt ist,
wobei der Halbleiterkörper (11) umfasst:
- eine Driftschicht (16) eines ersten Leitfähigkeitstyps,
- eine Wannenschicht (27) eines zweiten Leitfähigkeitstyps, der sich von dem ersten Leitfähigkeitstyp unterscheidet, die einen ersten Übergang (18) zu der Driftschicht (16) bildet,
- eine Source-Region (20) des ersten Leitfähigkeitstyps, die einen zweiten Übergang (21) zu der Wannenschicht (27) bildet, und
- eine Inselregion (30) des zweiten Leitfähigkeitstyps, wobei die Source-Region (20) die Inselregion (30) von der Wannenschicht (27) in mindestens 50% eines Inseloberflächenbereichs der Inselregion (30) in dem Halbleiterkörper (11) trennt, **dadurch gekennzeichnet, dass**
- die Source-Region (20) die Form einer ineinandergreifenden Fingerstruktur aufweist,
- die Wannenschicht (27) sich zwischen Fingern (32, 32') der ineinandergreifenden Fingerstruktur befindet,
- die Inselregion (30) sich in einem Finger (32) der ineinandergreifenden Fingerstruktur an der ersten Hauptfläche (12) befindet.

2. Leistungshalbleitervorrichtung (10) nach Anspruch 1, wobei die Wannenschicht (27) eine Wannenregion (17), die die Source-Region (20) von der Driftschicht (16) trennt, und eine Wannen-Kontaktregion (19) an der ersten Hauptfläche (12) umfasst, die eine höhere maximale Dotierungskonzentration aufweist als die Wannenregion (17).

3. Leistungshalbleitervorrichtung (10) nach Anspruch 2, wobei ein Abstand (D) der Inselregion (30) zu der Wannenkontaktregion (19) größer als 0,05 um ist.

4. Leistungshalbleitervorrichtung (10) nach Anspruch 2 oder 3, wobei die Leistungshalbleitervorrichtung (10) eine Source-Elektrode (22) umfasst, die zumindest an einem Teil der Source-Region (20) und zumindest an einem Teil der Wannenkontaktregion (19) angeordnet ist,
wobei die Source-Elektrode (22) einen ohmschen Kontakt zu der Source-Region (20) und zu der Wannenkontaktregion (19) bildet, und
wobei die Source-Elektrode (22) frei von einem ohmschen Kontakt zu der Inselregion (30) ist.

5. Leistungshalbleitervorrichtung (10) nach Anspruch 2 oder 3, wobei die Leistungshalbleitervorrichtung (10) eine Source-Elektrode (22) umfasst, die zumindest an einem Teil der Source-Region (20) und zumindest an einem Teil der Wannenschicht (27) und zumindest an einem Teil der Inselregion (30) angeordnet ist, und wobei die Source-Elektrode (22) einen ohmschen Kontakt zu der Source-Region (20) und zu der Wannenschicht (27) und zu der Inselregion (30) bildet.

6. Leistungshalbleitervorrichtung (10) nach einem der Ansprüche 1 bis 5,
wobei die Inselregion (30) frei von einem leitenden Kontakt zu der Driftschicht (16) über eine Halbleiterregion ist und frei von einem leitenden Kontakt zu der Wannenschicht (27) über eine Halbleiterregion ist.

7. Leistungshalbleitervorrichtung (10) nach einem der Ansprüche 1 bis 6,
wobei eine maximale Dotierungskonzentration der Inselregion (30) in einem Bereich zwischen 0,5 10¹⁸ cm⁻³ and 2 10²¹ cm⁻³ liegt.

8. Leistungshalbleitervorrichtung (10) nach einem der Ansprüche 1 bis 7,
wobei die Inselregion (30) in einer Ebene parallel zur ersten Hauptfläche (12) ausgebildet ist als eines aus einer Gruppe, die ein Rechteck, ein Trapez, ein Sechseck, einen Kreis und ein Ellipsoid umfasst.

9. Leistungshalbleitervorrichtung (10) nach einem der Ansprüche 1 bis 8, wobei mindestens eines der folgenden Merkmale vorliegt:
- der Halbleiterkörper (11) ist aus einem Material mit breiter Bandlücke oder aus Siliziumkarbid oder aus Silizium, oder
- die Leistungshalbleitervorrichtung (10) ist ein Feldeffekttransistor oder ein Bipolartransistor mit isoliertem Gate.

10. Leistungshalbleitervorrichtung (10) nach einem der Ansprüche 1 bis 9,
wobei eine Dicke der Inselregion (30) weniger als 95% einer Dicke der Source-Region (20) beträgt.

11. Leistungshalbleitervorrichtung (10) nach einem der Ansprüche 1 bis 10,
wobei der Halbleiterkörper (11) eine Anzahl N an Inselregionen (30) beinhaltet.

12. Leistungshalbleitervorrichtung (10) nach einem der Ansprüche 1 bis 11,
wobei eine Inselregionlänge (L) der Inselregion (30) einen Wert in einem Bereich zwischen 5% und 95% einer Source-Regionlänge (LS) der Source-Region (20) aufweist.

## Revendications

1. Dispositif semi-conducteur (10) de puissance, comportant :
- un corps semi-conducteur (11) qui comprend une première surface principale (12) et une seconde surface principale (13),
- un isolant (14) de grille disposé au niveau de la première surface principale (12), et
- une électrode (15) de grille séparée du corps semi-conducteur (11) par l'isolant (14) de grille,
le corps semi-conducteur (11) comportant
- une couche (16) de dérive d'un premier type de conductivité,
- une couche (27) de puits d'un second type de conductivité qui est différent du premier type de conductivité et formant une première jonction (18) vers la couche (16) de dérive,
- une région (20) de source du premier type de conductivité formant une seconde jonction (21) vers la couche (27) de puits, et
- une région (30) d'îlot du second type de conductivité, la région (20) de source séparant la région (30) d'îlot de la couche (27) de puits dans au moins 50 % d'une superficie d'îlot de la région (30) d'îlot dans le corps semi-conducteur (11), **caractérisé en ce que**
- la région (20) de source présente la forme d'une structure en doigts interdigitée,
- la couche (27) de puits est située entre des doigts (32, 32') de la structure en doigts interdigitée,
- la région (30) d'îlot est située dans un doigt (32) de la structure en doigts interdigitée au niveau de la première surface principale (12).

2. Dispositif semi-conducteur (10) de puissance selon la revendication 1, la couche (27) de puits comportant une région (17) de puits séparant la région (20) de source de la couche (16) de dérive et une région (19) de contact de puits au niveau de la première surface principale (12) qui présente une concentration maximum de dopage plus élevée que la région (17) de puits.

3. Dispositif semi-conducteur (10) de puissance selon la revendication 2, une distance (D) de la région (30) d'îlot à la région (19) de contact de puits étant supérieure à 0,05 µm.

4. Dispositif semi-conducteur (10) de puissance selon la revendication 2 ou 3, le dispositif semi-conducteur (10) de puissance comportant une électrode (22) de source disposée au moins au niveau d'une partie de la région (20) de source et au moins au niveau d'une partie de la région (19) de contact de puits,
l'électrode (22) de source formant un contact ohmique vers la région (20) de source et vers la région (19) de contact de puits, et
l'électrode (22) de source étant exempte d'un contact ohmique vers la région (30) d'îlot.

5. Dispositif semi-conducteur (10) de puissance selon la revendication 2 ou 3, le dispositif semi-conducteur (10) de puissance comportant une électrode (22) de source disposé au moins au niveau d'une partie de la région (20) de source et au moins au niveau d'une partie de la couche (27) de puits et au moins au niveau d'une partie de la région (30) d'îlot, et l'électrode (22) de source formant un contact ohmique vers la région (20) de source et vers la couche (27) de puits et vers la région (30) d'îlot.

6. Dispositif semi-conducteur (10) de puissance selon une des revendications 1 à 5,
la région (30) d'îlot étant exempte d'un contact passant vers la couche (16) de dérive par l'intermédiaire d'une région semiconductrice et étant exempte d'un contact passant vers la couche (27) de puits par l'intermédiaire d'une région semiconductrice.

7. Dispositif semi-conducteur (10) de puissance selon une des revendications 1 à 6,
une concentration maximum de dopage de la région (30) d'îlot se trouvant dans une plage comprise entre 0,5 10¹⁸ cm⁻³ et 2 10²¹ cm⁻³.

8. Dispositif semi-conducteur (10) de puissance selon une des revendications 1 à 7,
la région (30) d'îlot étant formée comme une forme d'un groupe comprenant un rectangle, un trapézoïde, un hexagone, un cercle et un ellipsoïde dans un plan parallèle à la première surface principale (12).

9. Dispositif semi-conducteur (10) de puissance selon une des revendications 1 à 8, au moins une des propositions suivantes étant vérifiée:
- le corps semi-conducteur (11) est constitué d'un matériau à large bande interdite, ou de carbure de silicium, ou de silicium, ou
- le dispositif semi-conducteur (10) de puissance est un transistor à effet de champ ou un transistor bipolaire à grille isolée.

10. Dispositif semi-conducteur (10) de puissance selon une des revendications 1 à 9,
une épaisseur de la région (30) d'îlot étant inférieure à 95% d'une épaisseur de la région (20) de source.

11. Dispositif semi-conducteur (10) de puissance selon une des revendications 1 à 10,
le corps semi-conducteur (11) comprenant un nombre N de régions (30) d'îlots.

12. Dispositif semi-conducteur (10) de puissance selon une des revendications 1 à 11,
une longueur (L) de région d'îlot de la région (30) d'îlot présentant une valeur située dans une plage comprise entre 5 % et 95 % d'une longueur (LS) de région de source de la région (20) de source.
